# EUROPÄISCHE PATENTSCHRIFT

(11) **EP 3 135 075 B1**
(45) Veröffentlichungstag und Bekanntmachung des Hinweises auf die Patenterteilung: **08.04.2020**
(21) Anmeldenummer: 15717174.5
(22) Anmeldetag: 21.04.2015
(51) Int. Cl.: H05B 3/84, H05B 1/02, H03K 17/96, H05B 3/06, B32B 17/10

(54) **ELEKTRISCH BEHEIZBARE SCHEIBE MIT SCHALTBEREICH**
ELECTRICALLY HEATABLE PANEL WITH SWITCH REGION
VITRE ÉLECTRIQUEMENT CHAUFFANTE COMPRENANT UNE ZONE DE COMMANDE

(30) Priorität: 24.04.2014 EP 14165740
(43) Veröffentlichungstag der Anmeldung: 01.03.2017
(73) Patentinhaber: Saint-Gobain Glass France, 92400 Courbevoie (FR)
(72) Erfinder: WEBER, Patrick, 52477 Alsdorf (DE); ESSER, Hans-Georg, 52064 Aachen (DE); BONDKOWSKI, Jens, 75013 Paris (FR)
(74) Vertreter: Gebauer, Dieter Edmund
(86) Internationale Anmeldenummer: PCT/EP2015/058553
(87) Internationale Veröffentlichungsnummer: WO 2015/162108

(56) Entgegenhaltungen:
- WO-A1-2008/113978
- WO-A1-2011/036010
- WO-A1-2013/053611
- WO-A1-2013/091961
- WO-A2-2004/062908
- DE-A1-102012 018 001
- US-A1- 2007 020 465
- US-A1- 2007 194 216

## Beschreibung

Die Erfindung betrifft eine elektrisch beheizbare Scheibe mit Schaltbereich, eine Scheibenanordnung, ein Verfahren zur Herstellung der Scheibe und deren Verwendung.

Das Sichtfeld einer Fahrzeugscheibe, insbesondere einer Windschutzscheibe muss frei von Eis und Beschlag gehalten werden. Bei Kraftfahrzeugen mit Verbrennungsmotor kann beispielsweise ein mittels Motorwärme erwärmter Luftstrom auf die Scheiben gelenkt werden.

Alternativ kann die Scheibe eine elektrische Heizfunktion aufweisen. So sind Verbundscheiben bekannt, die auf einer innenseitigen Oberfläche einer der Einzelscheiben eine elektrische Heizschicht aus einer transparenten, elektrisch leitfähigen Beschichtung aufweisen. Durch eine externe Spannungsquelle kann ein elektrischer Strom durch die elektrisch leitfähige Beschichtung geleitet werden, der die Beschichtung und damit die Scheibe erwärmt. WO2012/052315 A1 offenbart beispielsweise eine solche beheizbare, elektrisch leitfähige Beschichtung auf Metallbasis.

Die elektrische Kontaktierung der elektrischen Heizschicht erfolgt typischerweise über Sammelleiter, wie aus US 2007/0020465 A1 bekannt ist. Die Sammelleiter bestehen beispielsweise aus einer aufgedruckten und eingebrannten Silberpaste. Die Sammelleiter verlaufen typischerweise entlang der oberen und unteren Kante der Scheibe. Die Sammelleiter sammeln den Strom, der durch die elektrische Heizschicht fließt und leiten ihn zu externen Zuleitungen, die mit einer Spannungsquelle verbunden sind. Üblicherweise wird die Spannung die an der elektrischen Heizschicht anliegt durch externe Schalter gesteuert, die bei Fahrzeugen beispielsweise in einem Armaturenbrett integriert sind. Derartige Scheiben können auch mehrere Sammelleiter aufweisen, die mit mehreren Spannungsquellen verbunden sind, so dass gewisse Bereich zusätzlich geheizt werden können, wie aus der DE 10 2012 018 001 A1 bekannt ist.

Es ist bekannt, dass Schaltflächen durch eine Linien- oder eine Flächenelektrode oder durch eine Anordnung von zwei gekoppelten Elektroden ausgebildet werden können, beispielsweise als kapazitive Schaltflächen. Beispiele finden sich in der US 2007/0194216 A1. Nähert sich ein Objekt der Schaltfläche, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Schalter sind beispielsweise aus DE 20 2006 006 192 U1, EP 0 899 882 A1, US 6,452,514 B1 und EP 1 515 211 A1 bekannt.

Die internationale Patentanmeldung WO 2004/062908 A2 zeigt eine Scheibe mit einem rechteckförmig ausgebildeten, kapazitiven Sensorfeld, das sich bis zum Scheibenrand erstreckt. us der internationalen Patentanmeldung WO 2013/091961 A1 ist eine Verbundscheibe mit Antennenstruktur und integrierter Schaltfläche bekannt.

Die Aufgabe der vorliegenden Erfindung besteht darin, eine verbesserte elektrisch beheizbare Scheibe bereitzustellen, die einen Schaltbereich aufweist, der einfach und kostengünstig in die Scheibe integriert werden kann, der die Durchsicht durch Scheibe nicht behindert und eine annähernd gleichmäßige Heizleistungsverteilung in der Scheibe aufweist.

Die Aufgabe der vorliegenden Erfindung wird erfindungsgemäß durch eine elektrisch beheizbare Scheibe mit Schaltbereich gemäß dem unabhängigen Anspruch 1 gelöst. Bevorzugte Ausführungen gehen aus den Unteransprüchen hervor.

Die erfindungsgemäße elektrisch beheizbare Scheibe mit Schaltbereich umfasst zumindest die folgenden Merkmale:
- ein transparentes Substrat mit einer Oberfläche,
- mindestens eine transparente, elektrische leitfähige Schicht, die zumindest auf einem Teil der Oberfläche angeordnet ist,
- mindestens eine Trennlinie, die die Schicht in einen Heizbereich und einen Schaltbereich elektrisch unterteilt,
- mindestens zwei zum Anschluss an eine Spannungsquelle vorgesehene Sammelleiter, die mit dem Heizbereich so verbunden sind, dass zwischen den Sammelleitern ein Strompfad für einen Heizstrom geformt ist,
wobei der Schaltbereich mindestens einen Berührungsbereich, einen Zuleitungsbereich und einen Anschlussbereich aufweist und der Anschlussbereich mit einer Sensorelektronik elektrisch verbindbar ist.

Der Zuleitungsbereich verbindet den Berührungsbereich mit dem Anschlussbereich elektrisch.

Die Schicht ist durch mindestens eine Trennlinie in einen Heizbereich und einen Schaltbereich elektrisch unterteilt. Der Schaltbereich weist drei Bereiche auf: einen Berührungsbereich, einen Zuleitungsbereich und einen Anschlussbereich. Es ist somit klar, dass sowohl der Berührungsbereich, der Zuleitungsbereich und der Anschlussbereich Bereiche der Schicht sind. Es versteht sich daher, dass Berührungsbereich, Zuleitungsbereich und Anschlussbereich auch aus dem Material der Schicht bestehen. Die Bereiche sind derart zusammenhängend und dadurch elektrisch leitend miteinander verbunden, dass der Zuleitungsbereich den Berührungsbereich mit dem Anschlussbereich elektrisch verbindet.

In einer vorteilhaften Ausgestaltung der erfindungsgemäßen Scheibe ist die Längsrichtung des Zuleitungsbereichs im Wesentlichen in Richtung des Strompfads des Heizstroms angeordnet. Im Wesentlichen bedeutet hier, dass der Winkel α zwischen dem Strompfad und der Längsrichtung des Zuleitungsbereichs von 0° bis 45°, bevorzugt von 0° bis 20° und besonders bevorzugt von 0° bis 10° beträgt. Dies ist besonders vorteilhaft, da der Zuleitungsbereich den Stromfluss durch den Heizbereich nur wenig stört. Sind Strompfad und Zuleitungsbereich nicht geradlinig, so bedeutet Richtung des Strompfads und Längsrichtung des Zuleitungsbereichs jeweils die gemittelte Richtung.

In einer weiteren vorteilhaften Ausgestaltung der Erfindung beträgt das Verhältnis von Länge l_{Z} zu Breite b_{Z} des Zuleitungsbereichs kleiner oder gleich 1:700 und bevorzugt von 1:1 bis 1:100. Weist der Zuleitungsbereich keine konstante Breite b_{Z} auf, beispielsweise wenn er trapezförmig oder tropfenförmig ausgebildet ist, so wird im Rahmen der vorliegenden Erfindung unter der Breite b_{Z} die gemittelte Breite des Zuleitungsbereichs verstanden.

Die Länge l_{Z} des Zuleitungsbereichs beträgt bevorzugt von 1 cm bis 70 cm und besonders bevorzugt von 3 cm bis 8 cm. Die Breite b_{Z} des Zuleitungsbereichs beträgt bevorzugt von 0,5 mm bis 10 mm und besonders bevorzugt von 0,5 mm bis 2 mm. Die Form des Zuleitungsbereichs ist bevorzugt rechteckförmig, streifenförmig oder linienförmig.

In einer vorteilhaften Ausgestaltung der erfindungsgemäßen Scheibe ist der Anschlussbereich am äußeren Rand der Scheibe und/oder benachbart zu einem der Sammelleiter angeordnet. Dabei beträgt der Abstand zum äußeren Rand oder zum nächstgelegenen Sammelleiter bevorzugt weniger als 10 cm, besonders bevorzugt weniger als 0,5 cm. Dies erlaubt es eine elektrische Kontaktierung des Anschlussbereichs, beispielsweise mit einem Folienleiter, unter einem optisch unauffälligen Schwarzdruck oder mit einer Abdeckung, beispielsweise einem Kameragehäuse zu kaschieren.

In einer vorteilhaften Ausgestaltung des erfindungsgemäßen Schaltbereichs hat der Berührungsbereich eine Fläche von 1 cm² bis 200 cm², besonders bevorzugt von 1 cm² bis 9 cm². Die Länge l_{B} des Berührungsbereichs beträgt bevorzugt von von 1 cm bis 14 cm und besonders bevorzugt von 1 cm bis 3 cm. Die maximale Breite b_{B} des Berührungsbereichs beträgt bevorzugt von 1 cm bis 14 cm und besonders bevorzugt von 1 cm bis 3 cm. Der Berührungsbereich kann prinzipiell jede beliebige Form aufweisen. Besonders geeignet sind Formen, die eine gute Umleitung des Stromflusses des Heizstroms um die Berührungsfläche ermöglichen. Besonders geeignete Berührungsbereiche sind kreisförmig, elliptisch oder tropfenförmig ausgebildet. Alternativ sind eckige Formen möglich, beispielsweise Dreiecke, Quadrate, Rechtecke, Trapeze oder anders geartete Vierecke oder Polygone höherer Ordnung. Allgemein ist es besonders vorteilhaft, wenn etwaige Ecken abgerundet sind. Dies gilt für alle Bereiche des Schaltbereichs insbesondere im Übergangsbereich zwischen Berührungsbereich und Zuleitungsbereich und/oder Zuleitungsbereich und Anschlussbereich. Besonders vorteilhaft ist es, wenn die Ecken einen Krümmungsradius von mindestens 3 mm, bevorzugt von mindestens 8 mm aufweisen.

In einer weiteren vorteilhaften Ausgestaltung des erfindungsgemäßen Schaltbereichs beträgt das Verhältnis der Breite b_{Z} des Zuleitungsbereichs zur maximalen Breite b_{B} des Berührungsbereichs von mindestens 1:2 und insbesondere von mindestens 1:10. Dadurch konnten besonders gute Schaltergebnisse erzielt werden.

In einer vorteilhaften Ausgestaltung der erfindungsgemäßen Scheibe, beträgt die Breite d der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Scheib nicht oder nur geringfügig.

Eine weitere vorteilhafte Ausgestaltung der erfindungsgemäßen Scheibe umfasst eine Verbundscheibe, bei der die die elektrisch leitfähige Schicht aufweisende Oberfläche des Substrats über eine thermoplastische Zwischenschicht mit einer Deckscheibe flächig verbunden ist. Dies hat den Vorteil, dass der Schaltbereich und der Heizbereich hermetisch im Inneren der Verbundscheibe eingeschlossen und dadurch vor direkter Berührung und Korrosion geschützt sind.

Der Schaltbereich ist bevorzugt ein kapazitiver Schaltbereich. In einer vorteilhaften Ausgestaltung bildet der Schaltbereich dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein geerdeter Körper, in ihre Nähe kommt oder beispielsweise eine Isolatorschicht über der Flächenelektrode berührt. Die Isolatorschicht umfasst insbesondere das Substrat selbst oder eine Zwischenschicht oder eine Deckscheibe. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

Erfindungsgemäß weist die elektrisch leitfähige Schicht mindestens eine weitere Trennlinie auf, die die elektrisch leitfähige Schicht in einen Umgebungsbereich des Schaltbereichs elektrisch unterteilt. Es ist besonders vorteilhaft, wenn der Umgebungsbereich den Schaltbereich zumindest teilweise und bevorzugt vollständig umrandet. Ein derartiger Umgebungsbereich ist vorteilhaft, da dadurch der Einfluss des Heizbereichs und besonders eine Spannungsänderung im Heizbereich, auf den Schaltbereich verringert wird.

In einer weiteren vorteilhaften Ausgestaltung der erfindungsgemäßen Scheibe, weist der Umgebungsbereich eine ähnliche oder dieselbe Form wie der Schaltbereich auf. Insbesondere sind kreisförmige, elliptische oder tropfenförmige Formen oder Formen abgerundete Ecken sowie Streifenformen besonders vorteilhaft, da dadurch der Heizstrom besonders vorteilhaft um den Umgebungsbereich herum geleitet wird und keine oder nur geringe lokale Erhitzungen, sogenannte Hotspots, auftreten.

Ein erfindungsgemäßer Umgebungsbereich hat bevorzugt einen Abstand von weniger oder gleich 20 mm von der Trennlinie, die den Schaltbereich begrenzt, besonders bevorzugt von 5 mm bis 15 mm. Dadurch konnte der Schaltbereich besonders gut vom Heizbereich abgeschirmt werden.

Besonders vorteilhaft ist es, wenn der Umgebungsbereich einen weiteren Anschlussbereich aufweist, der mit der Sensorelektronik verbindbar ist.

In einer solchen Anordnung bilden der Schaltbereich und der Umgebungsbereich zwei Elektroden aus, die kapazitiv miteinander gekoppelt sind. Die Kapazität des von den Elektroden gebildeten Kondensators ändert sich bei Annäherung eines Körpers, beispielsweise eines menschlichen Körperteils. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt.

Alternativ kann der Schaltbereich auch induktive, thermische oder sämtliche andere Sensorfunktionen aufweisen, die berührungslos sind. Berührungslos bedeutet dabei, dass keine direkte Berührung der elektrisch leitfähigen Struktur zum Auslösen eines Schaltvorgangs notwendig ist. Es versteht sich, dass die Schaltfunktion auch bei direkter Berührung der elektrisch leitfähigen Struktur wirksam ist, falls die elektrisch leitfähige Struktur für den Benutzer zugänglich ist. Prinzipiell können auch Schaltbereiche mit berührungsabhängigen Sensorfunktionen ausgebildet sein.

Der Schaltbereich und gegebenenfalls der Umgebungsbereich ist in die erfindungsgemäße Scheibe integriert. Es ist also kein Schalter als separates Bauteil nötig, welches an der Scheibe angebracht werden muss. Die erfindungsgemäße Scheibe, welche als Einzelscheibe oder als Verbundscheibe ausgebildet sein kann, weist bevorzugt auch keine sonstigen Bauteile auf, die im Durchsichtbereich auf ihren Oberflächen angeordnet sind. Das ist besonders vorteilhaft im Hinblick auf eine dünne Bauweise der Scheibe sowie einer nur geringen Störung der Durchsicht durch die Scheibe.

Ein vorteilhafter Aspekt der Erfindung umfasst eine Scheibenanordnung mit einer erfindungsgemäßen Scheibe und einer Sensorelektronik, die über den Anschlussbereich mit der Schaltfläche und gegebenenfalls über einen weiteren Anschlussbereich mit der Umgebungsfläche elektrisch verbunden ist. Die Sensorelektronik ist bevorzugt eine kapazitive Sensorelektronik.

In eine vorteilhaften Ausgestaltung der erfindungsgemäßen Schaltanordnung ist die Empfindlichkeit der Sensorelektronik so gewählt ist, dass die Sensorelektronik bei Berührung des Berührungsbereichs mit einem menschlichen Finger auf dem Substrat ein Schaltsignal ausgibt und bei Berührung des Berührungsbereichs auf der Deckscheibe kein Schaltsignal oder ein anderes Schaltsignal ausgibt. Es versteht sich, dass die Berührung des Berührungsbereichs auch mit mehreren Fingern oder einem anderen menschlichen Körperteil erfolgen kann. Unter Berührung wird im Rahmen dieser Erfindung jegliche Wechselwirkung mit dem Schaltbereich verstanden, die zu einer messbaren Änderung des Messsignals, beispielsweise der Kapazität führt. Insbesondere ist dies eine unmittelbare Berührung des Schaltbereichs oder eine Berührung über einen Isolator hinweg, beispielsweise über die Dicke des Substrats oder die Dicke der Zwischenschicht oder die Dicke der Zwischen- und der Deckscheibe hinweg.
Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6 bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Die Empfindlichkeit der Sensorelektronik kann in Abhängigkeit der Größe des Berührungsbereichs und in Abhängigkeit der Dicke von Substrat, Zwischenschicht und Deckscheibe im Rahmen einfacher Experimente ermittelt werden. Insbesondere ergibt sich durch eine Zwischenschicht mit einer Permittivitätszahl von 2 bis 4 und bevorzugt einer minimalen Dicke von 0.5 mm, ein deutlicher Unterschied in der Kapazitätsänderung zwischen einer Berührung der Berührungsfläche über das Substrat im Vergleich mit einer Berührung über die Deckscheibe. Besonders vorteilhaft ist es dabei wenn die Deckscheibe dieselbe oder eine größere Dicke als das Substrat aufweist.

Der besondere Vorteil einer solchen erfindungsgemäßen Scheibenanordnung liegt darin, dass das Schaltsignal nur bei Berührung der Scheibe von einer Seite ausgelöst werden kann. Bei einer Verwendung der Scheibenanordnung in einer Fahrzeugscheibe und Einbau der Scheibe mit der Substratseite in Richtung des Fahrzeuginnenraums, kann beispielsweise ein Auslösen des Schaltvorgangs durch Personen von außen oder ein ungewolltes Auslösen des Schaltvorgangs durch Regen oder die Bewegung des Scheibenwischers sicher vermieden werden. Dies war für den Fachmann unerwartet und überraschend.

In Kombination mit der eben genannten Scheibenanordnung oder alternativ dazu, kann die Empfindlichkeit der Sensorelektronik so gewählt werden, dass sie bei Berührung des Berührungsbereichs auf dem Substrat und/oder der Deckscheibe mit einem menschlichen Finger ein Schaltsignal ausgibt und bei Berührung des Zuleitungsbereichs auf dem Substrat und/oder der Deckscheibe kein Schaltsignal oder ein anderes Schaltsignal ausgibt.

Die Empfindlichkeit der Sensorelektronik kann in Abhängigkeit der Größe des Berührungsbereichs und in Abhängigkeit der Geometrie sowie des Aspektverhältnisses zwischen Breite und Länge des Zuleitungsbereichs im Rahmen einfacher Experimente ermittelt werden. Besonders vorteilhaft ist es dabei, wenn die Breite des Zuleitungsbereichs möglichst gering gewählt wird.

Der besondere Vorteil dieser Ausführungsform einer erfindungsgemäßen Scheibenanordnung liegt darin, dass das Schaltsignal nur bei Berührung des Berührungsbereichs oder seiner unmittelbaren Umgebung ausgelöst werden kann und so eine präzise Steuerung des Schaltvorgangs möglich ist und beispielsweise ein versehentliches Schalten vermieden wird.

In einer vorteilhaften Weiterbildung einer erfindungsgemäßen Scheibenanordnung ist der Anschlussbereich mit einem Flachleiter verbunden und der Flachleiter ist aus der Scheibe herausgeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

Die Sammelleiter sind bevorzugt entlang der Seitenkante der elektrisch leitfähigen Schicht angeordnet. Die Länge des Sammelleiters ist typischerweise im Wesentlichen gleich der Länge der Seitenkante der elektrisch leitfähigen Schicht, kann aber auch leicht größer oder kleiner sein. Es können auch mehr als zwei Sammelleiter auf der elektrisch leitfähigen Schicht angeordnet sein, bevorzugt im Randbereich entlang zweier gegenüberliegenden Seitenkanten der elektrisch leitfähigen Schicht. Es können auch mehr als zwei Sammelleiter auf der elektrisch leitfähigen Schicht angeordnet sein, beispielsweise um zwei oder mehrere unabhängige Heizbereiche in einer Schicht auszubilden oder wenn der Sammelleiter durch eine oder mehrere unbeschichtete Zonen wie Kommunikationsfenster unterbrochen oder versetzt ist. Die erfindungsgemäße Lehre gilt dann für mindestens eines und bevorzugt für jedes der unabhängigen Heizbereiche.

In einer vorteilhaften Ausgestaltung ist der erfindungsgemäße Sammelleiter als aufgedruckte und eingebrannte leitfähige Struktur ausgebildet. Der aufgedruckte Sammelleiter enthält bevorzugt zumindest ein Metall, eine Metalllegierung, eine Metallverbindung und/oder Kohlenstoff, besonders bevorzugt ein Edelmetall und insbesondere Silber. Die Druckpaste enthält bevorzugt metallische Partikel Metallpartikel und/oder Kohlenstoff und insbesondere Edelmetallpartikel wie Silberpartikel. Die elektrische Leitfähigkeit wird bevorzugt durch die elektrisch leitenden Partikel erzielt. Die Partikel können sich in einer organischen und / oder anorganischen Matrix wie Pasten oder Tinten befinden, bevorzugt als Druckpaste mit Glasfritten.

Die Breite des ersten und zweiten Sammelleiters beträgt bevorzugt von 2 mm bis 30 mm, besonders bevorzugt von 4 mm bis 20 mm und insbesondere von 10 mm bis 20 mm. Dünnere Sammelleiter führen zu einen zu hohen elektrischen Widerstand und damit zu einer zu hohen Erwärmung des Sammelleiters im Betrieb. Des Weiteren sind dünnere Sammelleiter nur schwer durch Drucktechniken wie Siebdruck herzustellen. Dickere Sammelleiter erfordern einen unerwünscht hohen Materialeinsatz. Des Weiteren führen sie zu einer zu großen und unästhetischen Einschränkung des Durchsichtbereichs der Scheibe. Die Länge des Sammelleiters richtet sich nach der Ausdehnung des Heizbereichs. Bei einem Sammelleiter, der typischerweise in Form eines Streifens ausgebildet ist, wird die längere seiner Dimensionen als Länge und die weniger lange seiner Dimensionen als Breite bezeichnet. Die dritten oder zusätzlichen Sammelleiter können auch dünner ausgestaltet sein, bevorzugt von 0,6 mm bis 5 mm.

Die Schichtdicke des aufgedruckten Sammelleiters beträgt bevorzugt von 5 µm bis 40 µm, besonders bevorzugt von 8 µm bis 20 µm und ganz besonders bevorzugt von 8 µm bis 12 µm. Aufgedruckte Sammelleiter mit diesen Dicken sind technisch einfach zu realisieren und weisen eine vorteilhafte Stromtragfähigkeit auf.

Der spezifische Widerstand ρₐ der Sammelleiter beträgt bevorzugt von 0.8 µOhm•cm bis 7.0 µOhm•cm und besonders bevorzugt von 1.0 µOhm•cm bis 2.5 µOhm•cm. Sammelleiter mit spezifischen Widerständen in diesem Bereich sind technisch einfach zu realisieren und weisen eine vorteilhafte Stromtragfähigkeit auf.

Alternativ kann der Sammelleiter aber auch als Streifen einer elektrisch leitfähigen Folie ausgebildet sein. Der Sammelleiter enthält dann beispielsweise zumindest Aluminium, Kupfer, verzinntes Kupfer, Gold, Silber, Zink, Wolfram und/oder Zinn oder Legierungen davon. Der Streifen hat bevorzugt eine Dicke von 10 µm bis 500 µm, besonders bevorzugt von 30 µm bis 300 µm. Sammelleiter aus elektrisch leitfähigen Folien mit diesen Dicken sind technisch einfach zu realisieren und weisen eine vorteilhafte Stromtragfähigkeit auf. Der Streifen kann mit der elektrisch leitfähigen Struktur beispielsweise über eine Lotmasse, über einen elektrisch leitfähigen Kleber oder durch direktes Auflegen elektrisch leitend verbunden sein.

Die erfindungsgemäße Scheibe umfasst ein Substrat, auf der eine beheizbare elektrisch leitfähige Schicht angeordnet ist. Je nach Art der Schicht ist es vorteilhaft die Schicht mit einer Schutzschicht, beispielsweise einem Lack, einer Polymerfolie und/oder einer Deckscheibe zu schützen.

In einer vorteilhaften Ausgestaltung der erfindungsgemäßen Scheibe ist die Oberfläche des Substrats, auf der die transparente, elektrisch leitfähige Schicht angeordnet ist, über eine thermoplastische Zwischenschicht mit einer Deckscheibe flächig verbunden.

Als Substrat und gegebenenfalls Deckscheibe sind im Grunde alle elektrisch isolierenden Substrate geeignet, die unter den Bedingungen der Herstellung und der Verwendung der erfindungsgemäßen Scheibe thermisch und chemisch stabil sowie dimensionsstabil sind.

Das Substrat und/oder die Deckscheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Das Substrat und/oder die Deckscheibe sind bevorzugt transparent, insbesondere für die Verwendung der Scheibe als Windschutzscheide oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrrelevanten Sichtfeld des Fahrers liegen, beispielsweise für Dachscheiben, kann die Transmission aber auch viel geringer sein, beispielsweise größer als 5 %.

Die Dicke von Substrat und/oder Deckscheibe kann breit variieren und so hervorragend den Erfordernissen des Einzelfalls angepasst werden. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheibe kann breit variieren und richtet sich nach der Größe der erfindungsgemäßen Verwendung. Das Substrat und gegebenenfalls die Deckscheibe weisen beispielsweise im Fahrzeugbau und Architekturbereich übliche Flächen von 200 cm² bis zu 20 m² auf.

Die Scheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Substrate planar oder leicht oder stark in einer Richtung oder in mehreren Richtungen des Raumes gebogen. Insbesondere werden planare Substrate verwendet. Die Scheiben können farblos oder gefärbt sein.

Mehrere Substrate und/oder Deckscheiben werden durch mindestens eine Zwischenschicht miteinander verbunden. Die Zwischenschicht enthält vorzugsweise mindestens einen thermoplastischen Kunststoff, bevorzugt Polyvinylbutyral (PVB), Ethylenvinylacetat (EVA) und / oder Polyethylenterephthalat (PET). Die thermoplastische Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die thermoplastische Zwischenschicht kann durch eine oder auch durch mehrere übereinander angeordnete thermoplastische Folien ausgebildet werden, wobei die Dicke ein thermoplastischen Folie bevorzugt von 0,25 mm bis 1 mm beträgt, typischerweise 0,38 mm oder 0,76 mm.

Bei einer erfindungsgemäßen Verbundscheibe aus einem Substrat, einer Zwischenschicht und Deckscheibe kann die transparente, elektrisch leitfähige Schicht direkt auf das Substrat aufgebracht sein oder auf eine Trägerfolie oder auf die Zwischenschicht selbst aufgebracht sein. Das Substrat und die Deckscheibe weisen jeweils eine innenseitige Oberfläche und eine außenseitige Oberfläche auf. Die innenseitigen Oberflächen des Substrat und der Deckscheibe sind einander zugewandt und über die thermoplastische Zwischenschicht miteinander verbunden. Die außenseitigen Oberflächen des Substrat und der Deckscheibe sind voneinander und von der thermoplastischen Zwischenschicht abgewandt. Die transparente, elektrische leitfähige Schicht ist vorzugsweise auf der innenseitigen Oberfläche des Substrats aufgebracht. Natürlich kann auch auf der innenseitigen Oberfläche der Deckscheibe eine weitere elektrisch leitfähige Schichtung aufgebracht sein. Auch die außenseitigen Oberflächen der Scheiben können Beschichtungen aufweisen. Die Begriffe "Substrat" und "Deckscheibe" sind zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Scheibe beispielsweise dafür vorgesehen, in einer Öffnung, beispielsweise eines Fahrzeugs oder eines Gebäudes, den Innenraum gegenüber der äußeren Umgebung abzutrennen, so kann das Substrat dem Innenraum oder der äußeren Umgebung zugewandt sein.

Die elektrisch leitfähige Schicht enthält bevorzugt eine transparente, elektrisch leitfähige Beschichtung. Transparent bedeutet hier durchlässig für elektromagnetische Strahlung, vorzugsweise elektromagnetische Strahlung einer Wellenlänge von 300 nm bis 1.300 nm und insbesondere für sichtbares Licht.

Erfindungsgemäße elektrisch leitfähige Schichten sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und oder Chrom, oder eine Metalllegierung. Die funktionellen Schichten enthalten besonders bevorzugt mindestens 90 Gew. % des Metalls, insbesondere mindestens 99,9 Gew. % des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten der beheizbaren Beschichtung zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Dielektrische Schicht können aber auch mehrere Einzelschichten umfassen, beispielsweise Einzelschichten eines einem dielektrischen Material, Glättungsschichten, Anpassungsschichten, Blockerschichten und / oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete elektrisch leitfähige Schichten enthalten bevorzugt Indium-Zinnoxid (ITO), fluordotiertes Zinnoxid (SnO₂:F) oder aluminiumdotiertes Zinkoxid (ZnO:Al).

Die elektrisch leitfähige Schicht kann prinzipiell jede Beschichtung sein, die elektrisch kontaktiert werden kann. Soll die erfindungsgemäße Scheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die elektrisch leitfähige Schicht eine Schicht oder ein Schichtaufbau mehrerer Einzelschichten mit einer Gesamtdicke von kleiner oder gleich 2 □m, besonders bevorzugt kleiner oder gleich 1 □m.

Eine vorteilhafte erfindungsgemäße elektrisch leitfähige Schicht weist einen Flächenwiderstand von 0,4 Ohm/Quadrat bis 10 Ohm/Quadrat auf. In einer besonders bevorzugten Ausgestaltung weist die erfindungsgemäße elektrisch leitfähige Schicht einen Flächenwiderstand von 0,5 Ohm/Quadrat bis 1 Ohm/Quadrat auf. Beschichtungen mit derartigen Flächenwiderständen eignen sich besonders zur Beheizung von Fahrzeugscheiben bei typischen Bordspannungen von 12 V bis 48 Volt oder bei Elektrofahrzeugen mit typischen Bordspannungen von bis zu 500 V.

Die elektrisch leitfähige Schicht kann sich über die gesamte Oberfläche des Substrats erstrecken. Die elektrisch leitfähige Schicht kann sich alternativ aber auch nur über einen Teil der Oberfläche des Substrats erstrecken. Die elektrisch leitfähige Schicht erstreckt sich bevorzugt über mindestens 50%, besonders bevorzugt über mindestens 70% und ganz besonders bevorzugt über mindestens 90% der innenseitigen Oberfläche des Substrats. Die elektrisch leitfähige Schicht kann eine oder mehrere unbeschichtete Zonen aufweisen. Diese Zonen können für elektromagnetische Strahlung durchlässig sein und sind beispielsweise als Datenübertragungsfenster oder Kommunikationsfenster bekannt.

In einer vorteilhaften Ausgestaltung einer erfindungsgemäßen Scheibe als Verbundscheibe weist die innenseitige Oberfläche des Substrats einen umlaufenden Randbereich mit einer Breite von 2 mm bis 50 mm, bevorzugt von 5 mm bis 20 mm auf, der nicht mit der elektrisch leitfähige Schicht versehen ist. Die elektrisch leitfähige Schicht weist dann keinen Kontakt zur Atmosphäre auf und ist im Inneren der Scheibe durch die thermoplastische Zwischenschicht vorteilhaft vor Beschädigungen und Korrosion geschützt.

Die elektrische Zuleitung ist bevorzugt als Folienleiter oder flexibler Folienleiter (Flachleiter, Flachbandleiter) ausgebildet. Dies gilt sowohl für die Zuleitungen der Sammelleiter des Heizbereichs als auch für die Zuleitungen des Schaltbereichs, die mit dem oder den Anschlussbereichen verbunden sind. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können ohne Schwierigkeiten zwischen den einzelnen Scheiben in der thermoplastischen Zwischenschicht eingebettet werden. In einem Folienleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

In einer vorteilhaften Ausgestaltung der Erfindung wird die elektrische Zuleitung mit den Sammelleitern mit einem Kontaktband verbunden, beispielsweise mittels einer Lotmasse oder eines elektrisch leitfähigen Klebstoffs. Das Kontaktband ist dann mit dem Sammelleiter verbunden. Das Kontaktband erhöht vorteilhaft die Stromtragfähigkeit des Sammelleiters. Außerdem kann durch das Kontaktband eine unerwünschte Erhitzung der Kontaktstelle zwischen Sammelleiter und Zuleitung verringert werden. Zudem vereinfacht das Kontaktband die elektrische Kontaktierung des Sammelleiters durch die elektrische Zuleitung, weil die Zuleitung nicht mit dem bereits aufgebrachten Sammelleiter verbunden, beispielsweise verlötet werden muss.

Das Kontaktband enthält bevorzugt zumindest ein Metall, besonders bevorzugt Kupfer, verzinntes Kupfer, Silber, Gold, Aluminium, Zink, Wolfram und / oder Zinn. Das ist besonders vorteilhaft im Hinblick auf die elektrische Leitfähigkeit des Kontaktbandes. Das Kontaktband kann auch Legierungen enthalten, welche bevorzugt eines oder mehrere der genannten Elemente und gegebenenfalls weitere Elemente enthält, beispielsweise Messing oder Bronze. Das Kontaktband kann einfach auf den Sammelleiter aufgelegt sein und wird innerhalb der laminierten Scheibe dauerhaft stabil an der vorgesehenen Position fixiert.

In einer vorteilhaften Ausgestaltung der Erfindung weist die erfindungsgemäße Scheibe ein Lichteinstrahlmittel und ein Lichtablenkmittel auf. Lichteinstrahlmittel und Lichtablenkmittel sind dabei in oder am Substrat und/oder an der Deckscheibe angeordnet. Der Schaltbereich kann an der gleichen Oberfläche des Substrats wie das Lichtablenkmittel angeordnet sein. Dabei kann die elektrisch leitfähige Schicht mit dem Schaltbereich aus der Richtung des Substrats über oder unter dem Lichtablenkmittel oder in der gleichen Ebene wie das Lichtablenkmittel angeordnet sein. Alternativ können elektrisch leitfähige Schicht und das Lichtablenkmittel an den gegenüberliegenden Oberflächen des Substrats angeordnet sein.

Das Lichteinstrahlmittel umfasst erfindungsgemäß zumindest eine Lichtquelle, bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und / oder ästhetischen Gesichtspunkten. Das Lichteinstrahlmittel kann optische Elemente umfassen, insbesondere zur Lenkung des Lichts, bevorzugt einen Reflektor und / oder einen Lichtwellenleiter, beispielsweise eine Glasfaser oder eine polymere optische Faser. Das Lichteinstrahlmittel kann an einer beliebigen Stelle des Substrats oder der Deckscheibe angeordnet sein, insbesondere am Seitenrand des Substrats oder der Deckscheibe oder in einer kleinen Ausnehmung inmitten von Substrat oder Deckscheibe.

Das Lichtablenkmittel umfasst bevorzugt Partikel, Punktraster, Aufkleber, Anlagerungen, Einkerbungen, Einritzungen, Strichraster, Aufdrucke und / oder Siebdrucke und ist dazu geeignet das im Substrat oder in der Deckscheibe transportierte Licht aus demselben auszukoppeln.

Das Lichtablenkmittel kann an jeder beliebigen Position auf der Ebene des Substrats oder der Deckscheibe angeordnet sein. Besonders vorteilhaft ist es, wenn das Lichtablenkmittel im Bereich oder der unmittelbaren Umgebung des Schaltbereichs angeordnet ist und so ein schnelles Auffinden des ansonsten kaum sichtbaren Schaltbereichs ermöglicht. Dies ist insbesondere bei Nacht oder Dunkelheit besonders vorteilhaft.

Alternativ kann Licht durch einen Lichtleiter, der auf dem transparenten Substrat, der Zwischenschicht oder der Deckscheibe angeordnet ist, an den Schaltbereich herangeführt werden und diesen markieren.

Alternativ oder in Kombination kann das Lichteinstrahlmittel zusammen mit dem Lichtablenkmittel eine Information auf der Scheibe visualisieren, beispielsweise den Schaltzustand des Schaltbereichs wiedergeben oder anzeigen, ob die elektrische Beheizung der Scheibe eingeschaltet oder ausgeschaltet ist.

In einer alternativen vorteilhaften Ausgestaltung der erfindungsgemäßen Scheibe ist der Berührungsbereich durch eine aktive Lichtquelle direkt markierbar oder markiert, bevorzugt durch eine Leuchtdiode (LED), eine organische Leuchtdiode (OLED), eine Glühbirne oder andere aktive Leuchtkörper, wie ein lumineszentes Material, bevorzugt ein fluoreszierende oder phosphoreszierendes Material.

In einer weiteren alternativen vorteilhaften Ausgestaltung der erfindungsgemäßen Scheibe ist der Schaltbereich durch einen farbigen, bevorzugt einen weißen oder schwarzen, Aufdruck, beispielsweise einem Siebdruck, auf dem transparenten Substrat, der Zwischenschicht oder der Deckscheibe, markiert. Dies hat den besonderen Vorteil, dass der Schaltbereich unabhängig von einer Spannungsquelle und dauerhaft markiert ist. Der Aufdruck kann auch ein lumineszentes Material, bevorzugt ein fluoreszierende oder phosphoreszierendes Material enthalten und/oder nachleuchtend sein.

Die Erfindung umfasst weiter ein Verfahren zur Herstellung einer elektrisch beheizbaren Scheibe mit Schaltbereich, mindestens umfassend:
(a) Aufbringen einer transparenten, elektrisch leitfähigen Schicht auf eine Oberfläche (III) eines transparenten Substrats,
(b) Einbringen mindestens einer Trennlinie, die die Schicht in mindestens einen Heizbereich und einen Schaltbereich elektrisch unterteilt,
(c) Aufbringen von mindestens zwei zum Anschluss an eine Spannungsquelle vorgesehene Sammelleiter, die mit der Schicht so verbunden werden, dass zwischen den Sammelleitern ein Strompfad für einen Heizstrom geformt wird.

Es versteht sich, dass die Verfahrensschritte b) und c) auch in umgekehrter Reihenfolge erfolgen können, so dass zuerst die Sammelleiter auf der elektrisch leitfähigen Schicht angeordnet werden und anschließend die Trennlinien in die elektrisch leitfähige Schicht eingebracht werden.

Das Aufbringen der elektrisch leitfähigen Schicht in Verfahrensschritt (a) kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die elektrisch leitfähigen Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Das Substrat kann nach Verfahrensschritt (a) einer Temperaturbehandlung unterzogen werden. Dabei wird das Substrat mit der elektrisch leitfähigen Schicht auf eine Temperatur von mindestens 200°C, bevorzugt mindestens 300°C erwärmt. Die Temperaturbehandlung kann der Erhöhung der Transmission und / oder der Verringerung des Flächenwiderstands der elektrisch leitfähigen Schicht dienen.

Das Substrat kann nach Verfahrensschritt (a) gebogen werden, typischerweise bei einer Temperatur von 500 °C bis 700 °C. Da es technisch einfacher ist, eine plane Scheibe zu beschichten, ist dieses Vorgehen vorteilhaft, wenn das Substrat gebogen werden soll. Alternativ kann das Substrat aber auch vor Verfahrensschritt (a) gebogen werden, beispielsweise wenn die elektrisch leitfähigen Schicht nicht dazu geeignet ist, einen Biegeprozess ohne Beschädigungen zu überstehen.

Das Aufbringen des Sammelleiters in Verfahrensschritt (b) erfolgt bevorzugt durch Aufdrucken und Einbrennen einer elektrisch leitfähigen Paste in einem Siebdruckverfahren oder in einem Inkjet-Verfahren. Alternativ kann der Sammelleiter als Streifen einer elektrisch leitfähigen Folie auf die elektrisch leitfähigen Schicht aufgebracht, bevorzugt aufgelegt, angelötet oder angeklebt werden.

Bei Siebdruckverfahren erfolgt die laterale Formgebung durch die Maskierung des Gewebes, durch das die Druckpaste mit den Metallpartikeln gedrückt wird. Durch eine geeignete Formgebung der Maskierung kann beispielsweise die Breite b des Sammelleiters besonders einfach vorgeben und variiert werden.

Die Entschichtung einzelner Trennlinien in der elektrisch leitfähigen Schicht erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Eine vorteilhafte Weiterbildung des erfindungsgemäßen Verfahrens umfasst mindestens die folgenden weiteren Schritte:
(d) Anordnen einer thermoplastischen Zwischenschicht auf der beschichteten Oberfläche des Substrats und Anordnen einer Deckscheibe auf der thermoplastischen Zwischenschicht und
(e) Verbinden des Substrats mit der Deckscheibe über die thermoplastische Zwischenschicht.

In Verfahrensschritt (d) wird das Substrat so angeordnet, dass diejenige ihrer Oberflächen, welche mit der elektrisch leitfähigen Schicht versehen ist, der thermoplastischen Zwischenschicht zugewandt ist. Die Oberfläche wird dadurch zur innenseitigen Oberfläche des Substrats.

Die thermoplastische Zwischenschicht kann durch eine einzelne oder auch durch zwei oder mehrere thermoplastische Folien, die flächenmäßig übereinander angeordnet werden, ausgebildet werden.

Das Verbinden von Substrat und Deckscheibe in Verfahrensschritt (e) erfolgt bevorzugt unter Einwirkung von Hitze, Vakuum und/oder Druck. Es können an sich bekannte Verfahren zur Herstellung einer Scheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermoplastische Zwischenschicht und die zweite Scheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80°C bis 170°C laminiert werden.

Die Erfindung umfasst weiter die Verwendung der erfindungsgemäßen elektrisch beheizbaren Scheibe mit Schaltbereich in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und / oder Dachscheibe.

Die Erfindung umfasst weiter die Verwendung des Schaltbereichs der erfindungsgemäßen elektrisch beheizbaren Scheibe zur Steuerung und insbesondere zum Ein- und Ausschalten der Heizfunktion der Scheibe im Heizbereich.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer erfindungsgemäßen Scheibe,
- Figur 1B: eine vergrößerte Darstellung des Ausschnitts Z aus Figur 1A,
- Figur 1C: eine Querschnittsdarstellung entlang der Schnittlinie A-A' aus Figur 1A,
- Figur 1D: eine weitere Darstellung des Ausschnitts Z aus Figur 1A,
- Figur 2A: eine alternative Ausgestaltung einer erfindungsgemäßen Scheibe in einer vergrößerten Darstellung des Ausschnitts Z aus Figur 1A,
- Figur 2B: eine Querschnittsdarstellung entlang der Schnittlinie B-B' aus Figur 2A,
- Figur 3: eine weitere alternative Ausgestaltung einer erfindungsgemäßen Scheibe in einer vergrößerten Darstellung des Ausschnitts Z aus Figur 1A,
- Figur 4A: eine Draufsicht auf eine alternative Ausgestaltung der erfindungsgemäßen Scheibe,
- Figur 4B: eine vergrößerte Darstellung des Ausschnitts Z aus Figur 4A,
- Figur 4C: eine Querschnittsdarstellung entlang der Schnittlinie C-C' aus Figur 4A,
- Figur 5: ein detailliertes Flussdiagramm einer Ausführungsform des erfindungsgemäßen Verfahrens.

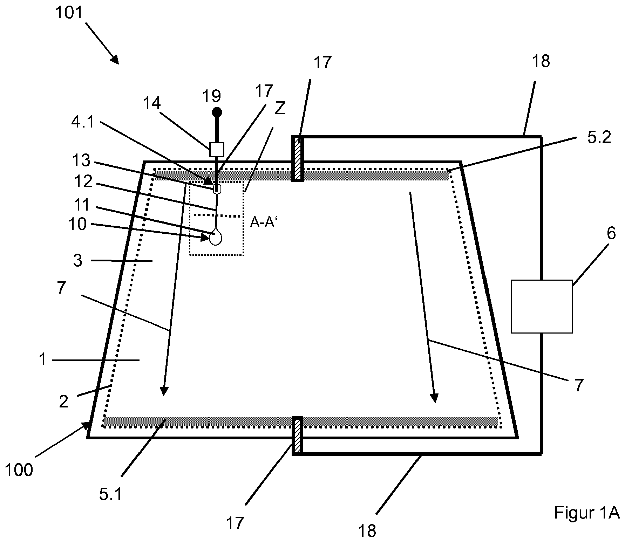

Figur 1A zeigt eine Draufsicht auf eine beispielhafte Ausgestaltung einer erfindungsgemäßen Scheibenanordnung 101 mit einer erfindungsgemäßen Scheibe 100. Die Scheibe 100 umfasst ein Substrat 1 und besteht beispielsweise aus Natron-Kalkglas. Auf einer der Oberfläche III des Substrats 1 ist eine elektrische leitfähige Schicht 2 aufgebracht. Die elektrische leitfähige Schicht 2 ist ein Schichtensystem, welches beispielsweise drei elektrisch leitfähige Silberschichten enthält, die durch dielektrische Schichten voneinander getrennt sind. Fließt ein Strom durch die elektrische leitfähige Schicht 2, so wird sie infolge ihres elektrischen Widerstands und joulscher Wärmeentwicklung erwärmt. Die elektrische leitfähige Schicht 2 kann daher für eine aktive Beheizung der Scheibe 100 verwendet werden. Die Abmessungen der Scheibe 100 betragen beispielsweise 0,9 m x 1,5 m.

Die elektrische leitfähige Schicht 2 ist durch eine Trennlinie 4.1 in einen Heizbereich 3 und einen Schaltungsbereich 10 unterteilt. Das heißt sowohl der Heizbereich 3 als auch der Schaltungsbereich 10 bestehen aus der elektrisch leitfähigen Schicht 2, sind aber voneinander durch die Trennlinie 4.1 elektrisch isoliert. Die Trennlinie 4.1 hat lediglich eine Breite von beispielsweise 100 µm und ist beispielsweise durch Laserstrukturierung in die elektrisch leitfähige Schicht 2 eingebracht. Trennlinien 4.1 mit einer derart geringen Breite sind optisch kaum wahrnehmbar und stören die Durchsicht durch die Scheibe 100 nur wenig, was besonders für eine Verwendung in Fahrzeugen von besonderer Wichtigkeit für die Fahrsicherheit ist.

Zur elektrischen Kontaktierung des Heizbereichs 3 ist jeweils ein erster Sammelleiter 5.1 im unteren Randbereich und ein weiterer, zweiter Sammelleiter 5.2 im oberen Randbereich des Heizbereichs 3 angeordnet. Die Sammelleiter 5.1, 5.2 enthalten beispielsweise Silberpartikel und wurden im Siebdruckverfahren aufgebracht und anschließend eingebrannt. Die Länge der Sammelleiter 5.1, 5.2 entspricht annähernd der Ausdehnung der elektrische leitfähige Schicht 2. Beide Sammelleiter 5.1,5.2 verlaufen annähernd parallel.

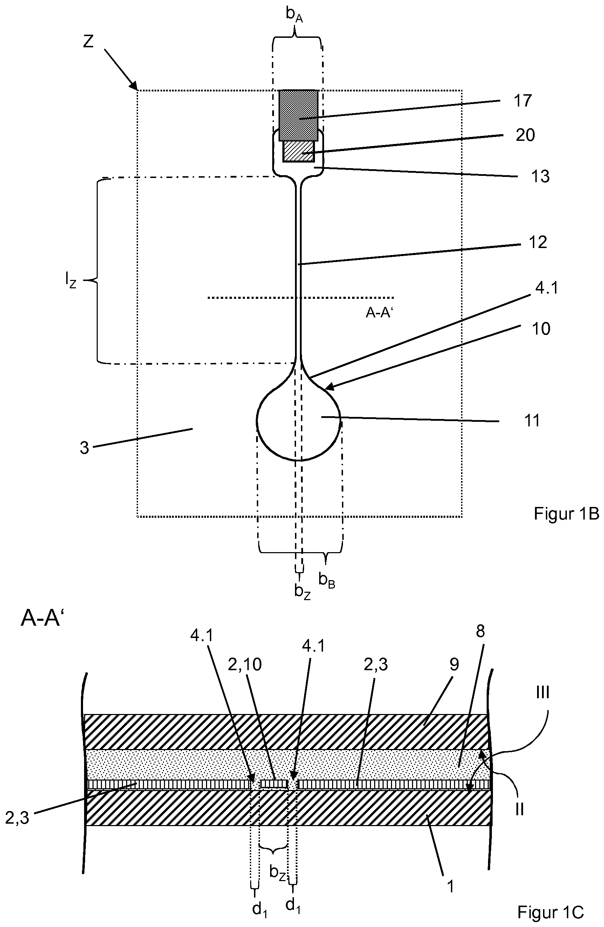

Figur 1B zeigt eine vergrößerte Darstellung des Ausschnitts Z aus Figur 1A. Der Schaltbereich umfasst einen Berührungsbereich 11, der annähernd tropfenförmig ausgebildet ist und in einen Zuleitungsbereich 12 übergeht. Tropfenförmig bedeutet hier, dass der Berührungsbereich 11 im Wesentlichen kreisförmig ist und sich an einer Seite trichterförmig zum Zuleitungsbereich 12 hin verjüngt. Die Breite b_{B} des Berührungsbereichs 11 beträgt beispielsweise 40 mm. Die Breite bz des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form mit abgerundeten Ecken und einer Kantenlänge b_{A} von beispielsweise 12 mm. Die Länge l_{Z} des Zuleitungsbereichs beträgt etwa 48 mm.

Der Anschlussbereich 13 ist über eine elektrische Leitungsverbindung 20 mit einem Folienleiter 17 elektrisch leitend verbunden. Der Folienleiter 17 besteht beispielsweise aus einer 50 µm dicken Kupferfolie und ist beispielsweise außerhalb der Anschlussbereichs 13 mit einer Polyimidschicht isoliert. Dadurch kann der Folienleiter 17 ohne elektrischen Kurzschluss über den Sammelleiter 5.2 hinweg über den oberen Rand der Scheibe 100 hinausgeführt werden. Es versteht sich, dass die elektrische Verbindung des Anschlussbereichs nach außen auch über isolierte Drähte oder über einen Bereich, in dem der Sammelleiter 5.2 unterbrochen ist, nach außen geführt werden kann.

Der Folienleiter 17 ist hier beispielsweise außerhalb der Scheibe 100 mit einer kapazitiven Sensorelektronik verbunden, die Kapazitätsänderungen des Schaltbereichs 10 gegenüber "Erde" misst und in Abhängigkeit eines Schwellwerts ein Schaltsignal über den Anschlusspunkt 19, beispielsweise an den CAN-Bus eines Fahrzeugs weitergibt. Über das Schaltsignal können beliebige Funktionen im Fahrzeug geschaltet werden, beispielsweise auch die Spannungsquelle 6 und damit die elektrische Beheizung der Scheibe 100 über den Heizbereich 3.

In Figur 1C ist eine Querschnittsdarstellung entlang der Schnittlinie A-A' aus Figur 1A. Die Scheibe 100 umfasst hier beispielsweise ein Substrat 1 und eine Deckscheibe 9, die über eine thermoplastische Zwischenschicht 8 miteinander verbunden sind. Die Scheibe 100 ist beispielsweise eine Fahrzeugscheibe und insbesondere die Windschutzscheibe eines Personenkraftwagens. Das Substrat 1 ist beispielsweise dafür vorgesehen, in Einbaulage dem Innenraum zugewandt zu sein. Das heißt, die Seite IV des Substrats 1 ist vom Innenraum aus zugänglich, wogegen Seite I der Deckscheibe nach außen weist. Substrat 1 und Deckscheibe 9 bestehen beispielsweise aus Natron-Kalkglas. Die Dicke des Substrats 1 beträgt beispielsweise 1,6 mm und die Dicke der Deckscheibe 9 beträgt 2,1 mm. Es versteht sich, dass Substrat 1 und Deckscheibe 9 beliebige Dicken aufweisen können und beispielsweise auch gleich dick ausgebildet sein können. Die thermoplastische Zwischenschicht 8 besteht aus Polyvinylbutyral (PVB) und weist eine Dicke von 0,76 mm auf. Auf der innenseitigen Oberfläche III des Substrats 1 ist die elektrisch leitfähige Schicht 2 aufgebracht.

Die elektrisch leitfähige Schicht 2 erstreckt sich beispielsweise über die gesamte Oberfläche III des Substrats 1 abzüglich eines umlaufenden rahmenförmigen unbeschichteten Bereichs mit einer Breite von 8 mm. Der unbeschichtete Bereich dient der elektrischen Isolierung zwischen der spannungsführenden, elektrisch leitfähigen Schicht 2 und der Fahrzeugkarosserie. Der unbeschichtete Bereich ist durch Verkleben mit der Zwischenschicht 8 hermetisch versiegelt, um die elektrisch leitfähige Schicht 2 vor Beschädigungen und Korrosion zu schützen.

Zur elektrischen Kontaktierung des Heizbereichs 3 der elektrisch leitfähigen Schicht 2 ist jeweils ein erster Sammelleiter 5.1 im unteren Randbereich und ein weiterer, zweiter Sammelleiter 5.2 im oberen Randbereich auf der elektrisch leitfähige Schicht 2 angeordnet. Die Sammelleiter 5.1, 5.2 enthalten beispielsweise Silberpartikel und wurden im Siebdruckverfahren aufgebracht und anschließend eingebrannt. Die Länge der Sammelleiter 5.1, 5.2 entspricht annähernd der Ausdehnung des Heizbereichs 3.

Wird an die Sammelleiter 5.1 und 5.2 eine elektrische Spannung angelegt, so fließt ein gleichmäßiger Strom durch die elektrisch leitfähige Schicht 2 des Heizbereichs 3 zwischen den Sammelleitern 5.1,5.2. Auf jedem Sammelleiter 5.1,5.2 ist ungefähr mittig ein Folienleiter 17 angeordnet. Der Folienleiter 17 ist über eine Kontaktfläche mit dem Sammelleiter 5.1,5.2 elektrisch leitend verbunden, beispielsweise mittels einer Lotmasse, eines elektrisch leitfähigen Klebstoffs oder durch einfaches Aufliegen und Andruck innerhalb der Scheibe 100. Der Folienleiter 17 enthält beispielsweise eine verzinnte Kupferfolie mit einer Breite von 10 mm und einer Dicke von 0,3 mm. Die Sammelleiter 5.1,5.2 sind über die Folienleiter 17 über Zuleitungen 18 mit einer Spannungsquelle 6 verbunden, welche eine für Kraftfahrzeuge übliche Bordspannung, bevorzugt von 12 V bis 15 V und beispielsweise etwa 14 V bereitstellt. Alternativ kann die Spannungsquelle 6 auch höhere Spannungen aufweisen, beispielsweise von 35 V bis 45 V und insbesondere 42 V.

Die Sammelleiter 5.1,5.2 haben im dargestellten Beispiel eine konstante Dicke von beispielsweise etwa 10 µm und einen konstanten spezifische Widerstand von beispielsweise 2.3 µOhm•cm.

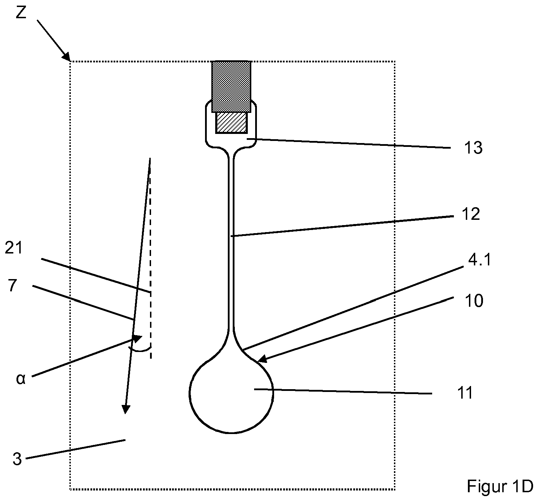

Figur 1D zeigt eine weitere Darstellung des Ausschnitts Z aus Figur 1A, wobei der mittlere Strompfad 7 in der Umgebung des Schaltbereichs 10 dargestellt ist. Die Längsrichtung des Zuleitungsbereichs 12 (hier dargestellt durch eine parallele gestrichelte Linie 21) weist einen Winkel α von beispielsweise 0,5° zur Richtung des Strompfads 7 auf. Dadurch wird der Stromfluss des Heizstroms bei Anlegen einer Spannung an die Sammelleiter 5.1,5.2 nur geringfügig durch den Zuleitungsbereich 12 gestört. Der Zuleitungsbereich 12 kann daher belieb lang gewählt werden, ohne dass der Verlauf des Heizstroms nennenswert gestört wird und ohne dass lokale Überhitzungen, sogenannte Hotspots, auf der Scheibe 100 auftreten.

Wird die Scheibe 100 beispielsweise als Windschutzscheibe in einem Kraftfahrzeug verwendet, kann die Länge des Zuleitungsbereichs 12 so gewählt werden, dass der Fahrer des Fahrzeugs oder der Beifahrer den Berührungsbereich 11 des Schaltbereichs 10 bequem erreichen.

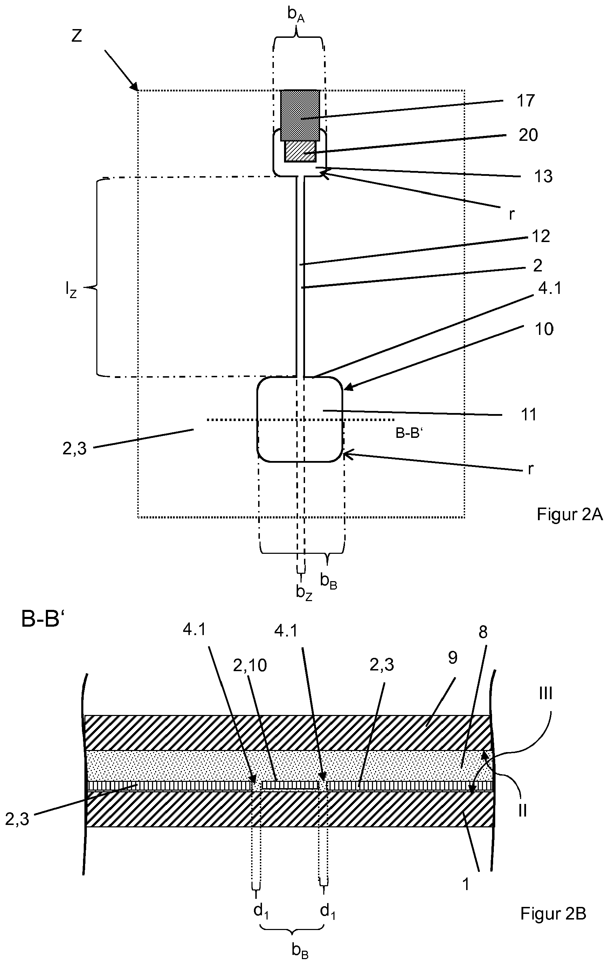

Figur 2A zeigt eine alternative Ausgestaltung einer erfindungsgemäßen Scheibe 100 in einer vergrößerten Darstellung des Ausschnitts Z aus Figur 1A. Der Schaltbereich 10 umfasst einen Berührungsbereich 11, der annähernd quadratisch ausgebildet ist, wobei die Ecken abgerundet ausgebildet sind und einen Krümmungsradius r von etwa 4 mm aufweisen. Der Berührungsbereich 11 geht in einen Zuleitungsbereich 12 über. Die Breite b_{B} und die Länge l_{B} des Berührungsbereichs 11 beträgt beispielsweise 40 mm. Die Breite b_{Z} des Zuleitungsbereichs 12 beträgt beispielsweise 1 mm. Der Zuleitungsbereich 12 ist mit einem Anschlussbereich 13 verbunden. Der Anschlussbereich 13 hat eine quadratische Form mit abgerundeten Ecken und einer Kantenlänge b_{A} von beispielsweise 12 mm. Der übrige Aufbau der Scheibe 100 entspricht beispielsweise dem Aufbau der Scheibe 100 aus Figur 1A.

Figur 2B zeigt eine Querschnittsdarstellung des Ausführungsbeispiels nach Figur 2A entlang der Schnittlinie B-B'.

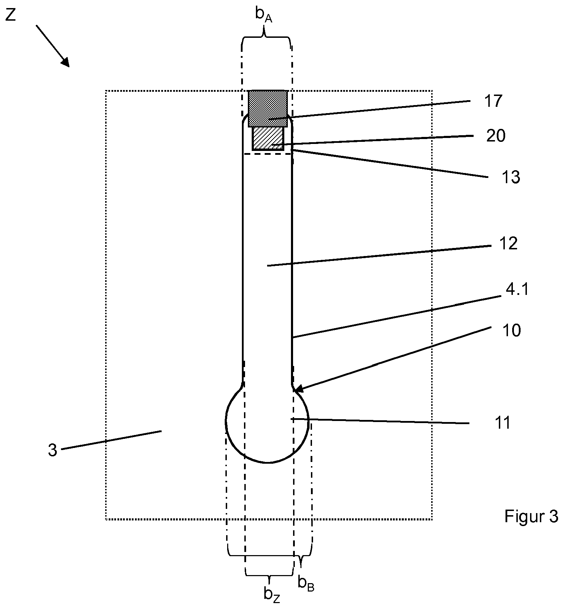

Figur 3 zeigt eine weitere alternative Ausgestaltung einer erfindungsgemäßen Scheibe 100 in einer vergrößerten Darstellung des Ausschnitts Z aus Figur 1A. Das Ausgestaltungsbeispiel der Scheibe 100 entspricht der Scheibe aus Figur 1A, wobei lediglich die Breite b_{Z} des Berührungsbereichs breiter ausgebildet ist und beispielsweise 30 mm beträgt.

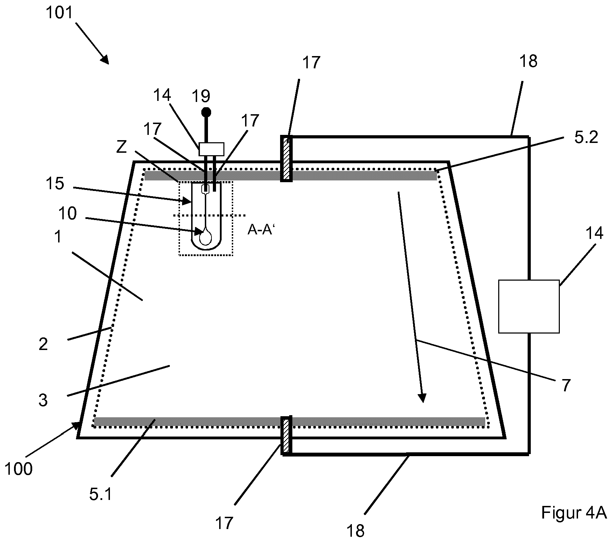

Figur 4A zeigt eine alternative Ausgestaltung einer erfindungsgemäßen Scheibenanordnung 101 mit einer Draufsicht auf eine erfindungsgemäße Scheibe 100, wobei die elektrisch leitfähige Schicht 2 einen Schaltbereich 10, einen Heizbereich 3 und einen Umgebungsbereich 15 aufweist. Ansonsten entspricht die Scheibe 100 dieses Ausgestaltungsbeispiels beispielsweise der Scheibe 100 aus Figur 1A.

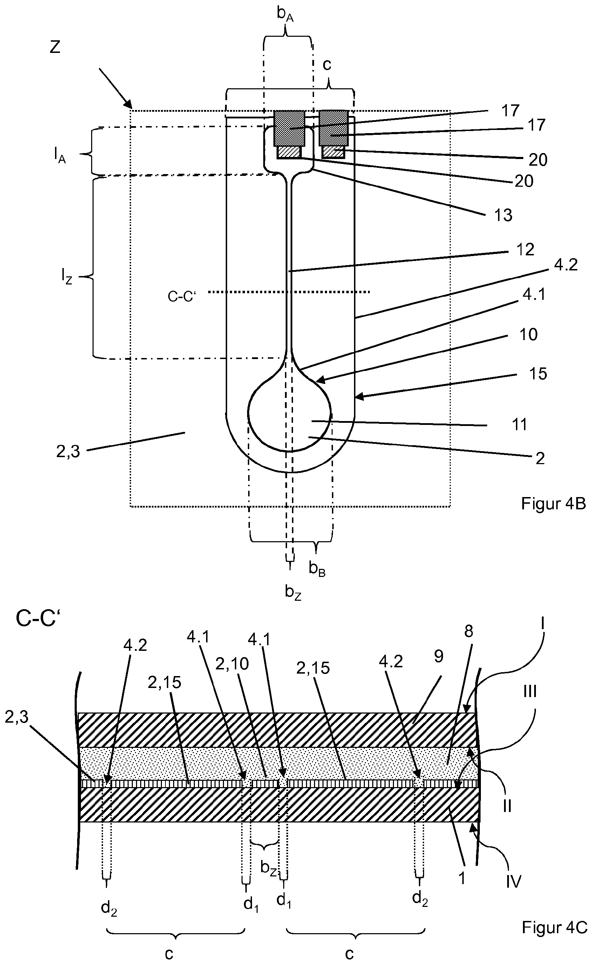

Figur 4B zeigt eine vergrößerte Darstellung des Ausschnitts Z aus Figur 4A. Der Umgebungsbereich 15 wird durch den Bereich zwischen der Trennlinie 4.1 und einer weiteren Trennlinie 4.2 gebildet, die den Umgebungsbereich 15 von dem Heizbereich 3 elektrisch unterteilt.

Figur 4C zeigt dazu eine Querschnittsdarstellung entlang der Schnittlinie C-C' aus Figur 4B. Sowohl der Schaltbereich 10, der Umgebungsbereich 15 als auch der Heizbereich 3 bestehen aus voneinander elektrisch isolierten Bereichen der elektrisch leitfähigen Schicht 2.

Die Trennlinien 4.1,4.2 haben lediglich eine Breite von beispielsweise 100 µm und sind beispielsweise durch Laserstrukturierung in die elektrische leitfähige Schicht 2 eingebracht. Trennlinien 4.1,4.2 mit einer derart geringen Breite sind optisch kaum wahrnehmbar und stören die Durchsicht durch die Scheibe 100 nur wenig, was besonders für eine Verwendung in Fahrzeugen von besonderer Wichtigkeit für die Fahrsicherheit ist.

Die Breite c des Umgebungsbereichs 15 beträgt beispielsweise 60 mm und umgibt den Schaltbereich 10 vollständig. Ein derartiger Umgebungsbereich 15 ist besonders vorteilhaft, da er den Abstand zwischen Schaltbereich 10 und Heizbereich 3 erhöht und dadurch eine präzisere Messung der Kapazität des Schaltbereichs 10 erlaubt. Gleichzeitig wird die Kapazitätsmessung dadurch weniger vom Heizstrom durch den Heizbereich 3 beeinflusst.

Der Umgebungsbereich 15 kann, wie hier dargestellt eine Anschlussstelle, aufweisen, die über eine elektrische Leitungsverbindung 20 mit einem Folienleiter 17 verbunden ist. Dies erlaubt den Anschluss einer Sensorelektronik mit zwei Eingängen, beispielsweise zur differenziellen Messung einer Kapazitätsänderung zwischen Schaltbereich 10 und Umgebungsbereich 15. Dies ist für eine präzise Messung von Kapazitätsunterschieden besonders vorteilhaft.

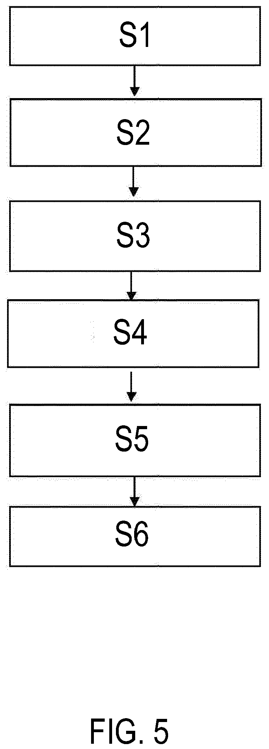

Figur 5 zeigt ein Flussdiagramm eines Ausführungsbeispiels des erfindungsgemäßen Verfahrens zur Herstellung einer elektrisch beheizbaren Scheibe 100 mit Schaltbereich 10:
S1: Aufbringen einer transparenten, elektrisch leitfähigen Schicht 2 auf die Oberfläche III eines Substrats 1 mittels Kathodenzerstäubung
S2: Einbringen mindestens einer Trennlinie 4.1, 4.2 durch Laserstrukturierung, die die Schicht 2 in mindestens einen Heizbereich 3 und einen Schaltbereich 10 elektrisch unterteilt
S3: Aufbringen von mindestens zwei zum Anschluss an eine Spannungsquelle 6 vorgesehenen Sammelleiter 5.1, 5.2, die mit der Schicht 2 so verbunden werden, dass zwischen den Sammelleitern 5.1, 5.2 ein Strompfad 7 für einen Heizstrom geformt wird
S4: Verbinden des Anschlussbereichs 13 des Schaltbereichs 10 mit einem Flachleiter 17 über eine elektrische Leitungsverbindung 20;
S5: Anordnen einer thermoplastischen Zwischenschicht 8 auf der Oberfläche III des Substrats 1 und Anordnen einer Deckschicht 9 auf der thermoplastischen Zwischenschicht 8;
S6: Verbinden des Substrats 1 mit der Deckschicht 9 über die thermoplastische Zwischenschicht 8 unter Einwirkung von Hitze, Vakuum und/oder Druck.

Die erfindungsgemäße Scheibe 100 nach den Figuren 1-4 weist einen Schaltbereich 10 auf, der beispielsweise mit einer kapazitiven Sensorelektronik 14 verbindbar ist. Gleichzeitig weist die Scheibe 100 einen elektrisch beheizbaren Heizbereich 3 auf, wobei die Heizfunktion und die Heizleistungsverteilung durch den Schaltbereich 10 nicht oder nur geringfügig beeinträchtigt wird. Außerdem ist, durch die geringe Breite der Trennlinien 4.1,4.2, die Sicht durch die Scheibe nur minimal beeinträchtigt und genügt beispielsweise den Anforderungen an eine Fahrzeugverglasung.

Besonders vorteilhaft und überraschend ist eine Scheibenanordnung 101 mit einer Verbundscheibe, bei der die Empfindlichkeit der Sensorelektronik 14 derart mit der Geometrie und den Abmessungen des Schaltbereichs 10 abgestimmt ist, dass eine selektive Auslösung des Schaltvorgangs nur von einer Seite der Scheibe 100 möglich ist.

Dieses Ergebnis war für den Fachmann unerwartet und überraschend.

### Bezugszeichenliste:

- 1: Substrat, transparentes Substrat
- 2: Schicht, transparente, elektrisch leitfähige Schicht
- 3: Heizbereich
- 4.1,4.2: Trennlinie
- 5.1,5.2: Sammelleiter
- 6: Spannungsquelle
- 7: Strompfad
- 8: Zwischenschicht
- 9: Deckscheibe, transparente Deckscheibe
- 10: Schaltbereich
- 11: Berührungsbereich
- 12: Zuleitungsbereich
- 13: Anschlussbereich
- 14: Sensorelektronik, kapazitive Sensorelektronik
- 15: Umgebungsbereich
- 16: weiterer Anschlussbereich
- 17: Folienleiter
- 18: Zuleitung
- 19: Anschlusspunkt CAN-Bus
- 20: elektrische Leitungsverbindung
- 21: Richtung des Zuleitungsbereichs 12

- α: Winkel zwischen Stromrichtung 7 und Richtung des Zuleitungsbereichs 12
- c: Breite des Umgebungsbereichs 15
- b_{A}: Breite des Anschlussbereichs 13
- b_{B}: Breite des Berührungsbereichs 11
- b_{Z}: Breite des Zuleitungsbereichs 12
- d₁,d₂: Breite der Trennlinie 4.1,4.2
- r: Krümmungsradius
- l_{A}: Länge des Anschlussbereichs 13
- l_{B}: Länge des Berührungsbereichs 11
- l_{Z}: Länge des Zuleitungsbereichs 12
- A-A': Schnittlinie
- B-B': Schnittlinie
- C-C': Schnittlinie
- Z: Ausschnitt

## Patentansprüche

1. Elektrisch beheizbare Scheibe (100) mit Schaltbereich (10), mindestens umfassend:
- ein transparentes Substrat (1) mit einer Oberfläche (III),
- mindestens eine transparente, elektrische leitfähige Schicht (2), die zumindest auf einem Teil der Oberfläche (III) angeordnet ist,
- mindestens eine Trennlinie (4.1), die die Schicht (2) in einen Heizbereich (3) und einen Schaltbereich (10) elektrisch unterteilt,
wobei
- der Schaltbereich (10) mindestens einen Berührungsbereich (11), einen Zuleitungsbereich (12) und einen Anschlussbereich (13) aufweist, so dass der Berührungsbereich (11), der Zuleitungsbereich (12) und der Anschlussbereich (13) zusammenhängende Bereiche der Schicht (2) sind,
- der Zuleitungsbereich (12) den Berührungsbereich (11) mit dem Anschlussbereich (13) elektrisch verbindet,
- der Anschlussbereich (13) mit einer Sensorelektronik (14) elektrisch verbindbar ist,
**gekennzeichnet durch** mindestens zwei zum Anschluss an eine Spannungsquelle (6) vorgesehene Sammelleiter (5.1, 5.2), die mit dem Heizbereich (3) so verbunden sind, dass zwischen den Sammelleitern (5.1,5.2) ein Strompfad (7) für einen Heizstrom geformt ist, und **dadurch, dass** mindestens eine weitere Trennlinie (4.2) die Schicht (2) in einen Umgebungsbereich (15) elektrisch unterteilt, der den Schaltbereich (10) zumindest teilweise und bevorzugt vollständig umrandet.

2. Scheibe (100) nach Anspruch 1, wobei der Zuleitungsbereich (12) eine Länge (l_{Z}) von 1 cm bis 70 cm und bevorzugt von 1 cm bis 8 cm aufweist und eine Breite (b_{Z}) von 0,5 mm bis 10 mm und bevorzugt von 0,5 mm bis 2 mm aufweist und bevorzugt rechteckförmig, streifenförmig oder linienförmig ist.

3. Scheibe (100) nach Anspruch 1 oder 2, wobei das Verhältnis von Länge (l_{Z}) zu Breite (b_{Z}) des Zuleitungsbereichs (12) kleiner oder gleich 1:700 und bevorzugt von 1:5 bis 1:100 beträgt.

4. Scheibe (100) nach einem der Ansprüche 1 bis 3, wobei der Anschlussbereich (13) am Rand der Scheibe (100) und/oder benachbart zu einem der Sammelleiter (5.1,5.2) angeordnet ist und bevorzugt ein jeweiliger Abstand kleiner oder gleich 10 cm beträgt.

5. Scheibe (100) nach einem der Ansprüche 1 bis 4, wobei die Fläche des Berührungsbereichs (11) von 1 cm² bis 200 cm², besonders bevorzugt von 1 cm² bis 9 cm² beträgt und/oder eine kreisförmige, elliptische oder tropfenförmige Form oder abgerundete Ecken aufweist.

6. Scheibe (100) nach Anspruch 1, wobei der Umgebungsbereich (15) kreisförmig, elliptisch, tropfenförmig oder streifenförmig und mit abgerundeten Ecken ausgebildet ist.

7. Scheibe (100) nach Anspruch 1 oder 6, wobei der Umgebungsbereich (15) einen weiteren Anschlussbereich (16) aufweist, der mit einer Sensorelektronik (14) verbindbar ist.

8. Scheibe (100) nach Anspruch 1 oder Anspruch 2, wobei die Breite (d_{1,2}) der Trennlinie (4.1,4.2) von 30 µm bis 200 µm und bevorzugt von 70 µm bis 140 µm beträgt.

9. Scheibe (100) nach einem der Ansprüche 1 bis 8, wobei die Oberfläche (III) des Substrats (1) über eine thermoplastische Zwischenschicht (8) mit einer Deckscheibe (9) flächig verbunden ist und die Zwischenschicht (8) bevorzugt eine Permittivitätszahl von 2 bis 4 aufweist.

10. Scheibe (100) nach einem der Ansprüche 1 bis 9, wobei das Substrat (1) und/oder die Deckscheibe (9) Glas, bevorzugt Flachglas, Floatglas, Quarzglas, Borosilikatglas, Kalk-Natron-Glas, oder Polymere, bevorzugt Polyethylen, Polypropylen, Polycarbonat, Polymethylmethacrylat und/oder Gemische davon enthält.

11. Scheibe (100) nach einem der Ansprüche 1 bis 10 wobei die Schicht (2) einen Flächenwiderstand von 0,4 Ohm/Quadrat bis 10 Ohm/Quadrat und bevorzugt von 0,5 Ohm/Quadrat bis 1 Ohm/Quadrat aufweist und/oder Silber, Indium-Zinnoxid , fluordotiertes Zinnoxid oder aluminiumdotiertes Zinkoxid enthält.

12. Scheibenanordnung (101) umfassend:
- eine elektrisch beheizbare Scheibe (100) nach einem der Ansprüche 9 bis 11 und
- eine Sensorelektronik (14), bevorzugt eine kapazitive Sensorelektronik (14), die mit dem Anschlussbereich (13) elektrisch verbunden ist,
wobei die Empfindlichkeit der Sensorelektronik (14) so gewählt ist, dass sie bei Berührung des Berührungsbereichs (11) mit einem menschlichen Finger auf dem Substrat (1) ein Schaltsignal ausgibt und bei Berührung des Berührungsbereichs (11) auf der Deckscheibe (9) kein Schaltsignal oder ein anderes Schaltsignal ausgibt.

13. Scheibenanordnung (101) umfassend:
- eine elektrisch beheizbare Scheibe (100) nach einem der Ansprüche 9 bis 11 und
- eine Sensorelektronik (14), bevorzugt eine kapazitive Sensorelektronik (14), die mit dem Anschlussbereich (13) elektrisch verbunden ist,
wobei die Empfindlichkeit der Sensorelektronik (14) so gewählt ist, dass sie bei Berührung des Berührungsbereichs (11) auf dem Substrat (1) und/oder der Deckscheibe (9) mit einem menschlichen Finger ein Schaltsignal ausgibt und bei Berührung des Zuleitungsbereichs (12) auf dem Substrat (1) und/oder der Deckscheibe (9) kein Schaltsignal oder ein anderes Schaltsignal ausgibt.

14. Scheibenanordnung (101) nach Anspruch 12 oder 13, wobei der Anschlussbereich (13) mit einem Flachleiter (17) verbunden ist und der Flachleiter (17) aus der Scheibe (100) herausgeführt ist.

15. Verfahren zur Herstellung einer elektrisch beheizbaren Scheibe (100) nach einem der Ansprüche 1 bis 11, mindestens umfassend:
(a) Aufbringen einer transparenten, elektrisch leitfähigen Schicht (2) auf eine Oberfläche (III) eines transparenten Substrats (1),
(b) Einbringen mindestens einer Trennlinie (4.1,4.2), die die Schicht (2) in mindestens einen Heizbereich (3) und einen Schaltbereich (10) elektrisch unterteilt, bevorzugt durch Laserstrukturierung oder durch mechanisches oder chemisches Abtragen, und
Aufbringen von mindestens zwei zum Anschluss an eine Spannungsquelle (6) vorgesehene Sammelleiter (5.1,5.2), die mit der Schicht (2) so verbunden werden, dass zwischen den Sammelleitern (5.1,5.2) ein Strompfad (7) für einen Heizstrom geformt wird.

16. Verwendung der Scheibe (100) nach einen der Ansprüche 1 bis 11 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper.

## Claims

1. Electrically heatable pane (100) with a switch region (10), at least comprising:
- a transparent substrate (1) with a surface (III),
- at least one transparent, electrically conductive layer (2), which is arranged at least on a part of the surface (III),
- at least one separating line (4.1) that electrically divides the layer (2) into a heating region (3) and a switch region (10),
wherein
- the switch region (10) has at least one contact region (11), a feed line region (12), and a connection region (13) such that the contact region (11), the feed line region (12), and the connection region (13) are contiguous regions of the layer (2),
- the feed line region (12) electrically connects the contact region (11) to the connection region (13),
- the connection region (13) can be electrically connected to sensor electronics (14),
**characterized in that** at least two busbars (5.1,5.2) provided for connection to a voltage source (6) that are connected to the heating region (3) such that a current path (7) for a heating current is formed between the busbars (5.1,5.2), and **in that** at least one additional separating line (4.2) electrically divides the layer (2) into a surrounding region (15), which surrounds the switch region (10) at least partially and preferably completely.

2. Pane (100) according to claim 1, wherein the feed line region (12) has a length (l_{Z}) of 1 cm to 70 cm and preferably of 1 cm to 8 cm and has a width (b_{Z}) of 0.5 mm to 10 mm and preferably of 0.5 mm to 2 mm and preferably has the shape of a rectangle, a strip, or a line.

3. Pane (100) according to claim 1 or 2, wherein the ratio of length (l_{Z}) to width bz of the feed line region (12) is less than or equal to 1:700 and is preferably from 1:5 to 1:100

4. Pane (100) according to one of claims 1 through 3, wherein the connection region (13) is arranged at the edge of the pane (100) and/or adjacent one of the busbars (5.1,5.2) and preferably a respective distance is less than or equal to 10 cm therefrom.

5. Pane (100) according to one of claims 1 through 4, wherein the area of the contact region (11) is from 1 cm² to 200 cm², particularly preferably from 1 cm² to 9 cm² and/or has the shape of a circle, an ellipse, or a drop or has rounded corners.

6. Pane (100) according to claim 1, wherein the surrounding region (15) is implemented in the shape of a circle, an ellipse, a drop, or a strip and with rounded corners.

7. Pane (100) according to claim 1 or 6, wherein the surrounding region (15) has an additional connection region (16), which can be connected to sensor electronics (14).

8. Pane (100) according to claim 1 or claim 2, wherein the width (d_{1,2}) of the separating line (4.1,4.2) is from 30 µm to 200 µm and preferably from 70 µm to 140 µm.

9. Pane (100) according to one of claims 1 through 8, wherein the surface (III) of the substrate (1) is areally connected to a cover pane (9) via a thermoplastic intermediate layer (8) and the intermediate layer (8) preferably has a permittivity number from 2 to 4.

10. Pane (100) according to one of claims 1 through 9, wherein the substrate (1) and/or the cover pane (9) contains glass, preferably flat glass, float glass, quartz glass, borosilicate glass, soda lime glass, or polymers, preferably polyethylene, polypropylene, polycarbonate, polymethyl methacrylate, and/or mixtures thereof.

11. Pane (100) according to one of claims 1 through 10, wherein the layer (2) has a sheet resistance of 0.4 ohm/square to 10 ohm/square and preferably of 0.5 ohm/square to 1 ohm/square and/or contains silver, indium tin oxide, fluorine-doped tin oxide, or aluminum-doped zinc oxide.

12. Pane arrangement (101) comprising:
- an electrically heatable pane (100) according to one of claims 9 through 11 and
- sensor electronics (14), preferably capacitive sensor electronics (14), which are electrically connected to the connection region (13),
wherein the sensitivity of the sensor electronics (14) is selected such that a switching signal is issued when the contact region (11) is touched on the substrate (1) by a human finger and no switching signal or a different switching signal is issued when the contact region (11) is touched on the cover pane (9).

13. Pane arrangement (101) comprising:
- an electrically heatable pane (100) according to one of claims 9 through 11 and
- sensor electronics (14), preferably capacitive sensor electronics (14), which are electrically connected to the connection region (13),
wherein the sensitivity of the sensor electronics (14) is selected such that a switching signal is issued when the contact region (11) is touched on the substrate (1) and/or the cover pane (9) human finger and no switching signal or a different switching signal is issued when the feed line region (12) is touched on the substrate (1) and/or the cover pane (9).

14. Pane arrangement (101) according to claim 12 or 13, wherein the connection region (13) is connected to a flat conductor (17) and the flat conductor (17) is guided out of the pane (100).

15. Method for producing an electrically heatable pane (100) according to one of claims 1 through 11, comprising at least:
(a) application of a transparent, electrically conductive layer (2) on a surface (III) of a transparent substrate (1),
(b) introduction of at least one separating line (4.1,4.2) that electrically divides the layer (2) into at least one heating region (3) and one switch region (10), preferably by laser patterning or by mechanical or chemical ablation, and
application of at least two busbars (5.1,5.2) provided for connection to a voltage source (6), which are connected to the layer (2) such that a current path (7) for a heating current is formed between the busbars (5.1,5.2).

16. Use of the pane (100) according to one of claims 1 through 11 in means of transportation for travel on land, in the air, or on water, in particular in motor vehicles, for example, as a windshield, rear window, side windows, and/or roof panel as well as a functional individual piece, and as a built-in component in furniture, devices, and buildings, in particular as an electric heater.

## Revendications

1. Vitre (100) pouvant être chauffée électriquement, avec une zone de commutation (10), comprenant au moins
- un substrat transparent (1) ayant une surface (III),
- au moins une couche transparente électriquement conductrice (2) disposée sur au moins une partie de la surface (III),
- au moins une ligne de séparation (4.1) qui divise électriquement la couche (2) en une zone de chauffage (3) et une zone de commutation (10),
où
- la zone de commutation (10) présente au moins une zone de contact (11), une zone d'alimentation (12) et une zone de connexion (13), de telle manière que la zone de contact (11), la zone d'alimentation (12) et la zone de connexion (13) sont des zones connectées de la couche (2),
- la zone d'alimentation (12) relie électriquement la zone de contact (11) à la zone de connexion (13)
- la zone de connexion (13) peut être reliée électriquement à une électronique de capteurs (14),
**caractérisé par** au moins deux conducteurs collectifs (5.1, 5.2) prévus pour le raccordement à une source de tension (6), qui sont reliés à la zone de chauffage (3) de telle manière qu'un trajet de courant (7) pour un courant de chauffage est formé entre les conducteurs collectifs (5.1, 5.2), et en ce qu'au moins une autre ligne de séparation (4.2) divise électriquement la couche (2) en une zone d'entourage (15) qui entoure au moins partiellement et de préférence complètement la zone de commutation (10).

2. Vitre (100) selon la revendication 1, où la zone d'alimentation (12) a une longueur (l_{z}) de 1 cm à 70 cm et de préférence de 1 cm à 8 cm et a une largeur (b_{z}) de 0,5 mm à 10 mm et de préférence de 0,5 mm à 2 mm et est de préférence rectangulaire, rayée ou linéaire.

3. Vitre (100) selon la revendication 1 ou 2, où le rapport entre la longueur (l_{z}) et la largeur (b_{z}) de la zone d'alimentation (12) est inférieure ou égale à 1:700 et de préférence de 1:5 à 1:100.

4. Vitre (100) selon l'une quelconque des revendications 1 à 3, où la zone de connexion (13) est disposée sur le bord du vitre (100) et/ou à proximité de l'un des conducteurs collectifs (5.1, 5.2) et présente de préférence une distance respective inférieure ou égale à 10 cm.

5. Vitre (100) selon l'une des revendications 1 à 4, où la surface de la zone de contact (11) est de 1 cm² à 200 cm², de préférence de 1 cm² à 9 cm² et/ou présente une forme circulaire, elliptique ou en goutte ou des coins arrondis.

6. Vitre (100) selon la revendication 1, où la région environnante (15) est circulaire, elliptique, en forme de goutte ou en bande et présente des coins arrondis.

7. Vitre (100) selon la revendication 1 ou 6, où la région environnante (15) présente une autre région de connexion (16) qui peut être reliée à une électronique de capteurs (14).

8. Vitre (100) selon la revendication 1 ou la revendication 2, où la largeur (d_{1,2}) de la ligne de séparation (4.1, 4.2) est de 30 µm à 200 µm et de préférence de 70 µm à 140 µm.

9. Vitre (100) selon l'une quelconque des revendications 1 à 8, où la surface (III) du substrat (1) est liée sur toute sa surface à une vitre de recouvrement (9) par l'intermédiaire d'une couche intermédiaire thermoplastique (8) et la couche intermédiaire (8) présente de préférence un indice de permittivité de 2 à 4.

10. Vitre (100) selon l'une des revendications 1 à 9, où le substrat (1) et/ou la vitre de recouvrement (9) contient du verre, de préférence du verre plat, du verre flotté, du verre de quartz, du verre borosilicaté, du verre sodocalcique ou des polymères, de préférence du polyéthylène, du polypropylène, du polycarbonate, du polyméthacrylate de méthyle et/ou des mélanges de ceux-ci.

11. Vitre (100) selon l'une des revendications 1 à 10, où la couche (2) présente une résistance de surface de 0,4 ohm/carré à 10 ohm/carré et de préférence de 0,5 ohm/carré à 1 ohm/carré et/ou contient de l'argent, de l'oxyde d'étain et d'indium, de l'oxyde d'étain dopé au fluor ou de l'oxyde de zinc dopé à l'aluminium.

12. Arrangement de vitres comprenant un ensemble de vitres (101) :
- un vitre (100) pouvant être chauffé électriquement selon l'une des revendications 9 à 11 et
- une électronique de capteurs (14), de préférence une électronique de capteurs capacitive (14), qui est reliée électriquement à la zone de raccordement (13),
où la sensibilité de l'électronique du capteurs (14) est sélectionnée de telle manière qu'elle émet un signal de commutation lorsqu'un doigt humain touche la surface de contact (11) sur le substrat (1) et lorsque la surface de contact (11) sur la vitre de couverture (9) est touchée n'émet pas de signal de commutation ni tout autre signal de commutation.

13. Arrangement de vitres (101) comprenant :
- une vitre (100) pouvant être chauffée électriquement selon l'une des revendications 9 à 11 et
- une électronique de capteur (14), de préférence une électronique de capteurs capacitive (14), qui est reliée électriquement à la zone de raccordement (13),
où la sensibilité de l'électronique de capteurs (14) est sélectionnée de cette manière, qu'elle émet un signal de commutation lorsque la zone de contact (11) sur le substrat (1) et/ou la vitre de recouvrement (9) est touchée par un doigt humain, et lorsque la zone de la ligne d'alimentation (12) sur le substrat (1) et/ou la vitre de recouvrement (9) est touchée n'émet pas de signal de commutation ni tout autre signal de commutation.

14. Arrangement de vitres (101) selon la revendication 12 ou 13, où la zone d'alimentation (13) est reliée à un conducteur plat (17) et le conducteur plat (17) s'étend hors de la vitre (100).

15. Procédé de fabrication d'une vitre (100) pouvant être chauffée électriquement selon l'une des revendications 1 à 11, comprenant au moins
(a) l'application d'une couche transparente et électriquement conductrice (2) sur une surface (III) d'un substrat transparent (1),
b) l'introduction d'au moins une ligne de séparation (4.1, 4.2) qui divise électriquement la couche (2) en au moins une zone de chauffage (3) et une zone de commutation (10), de préférence par structuration laser ou par ablation mécanique ou chimique, et l'application d'au moins deux conducteurs collectifs (5.1, 5.2) prévus pour le raccordement à une source de tension (6) qui sont reliés à la couche (2) de telle manière qu'un chemin de courant (7) pour un courant de chauffage est formé entre les conducteurs collectifs (5.1, 5.2).

16. L'utilisation de la vitre (100) selon l'une des revendications 1 à 11 dans des moyens de transport pour la circulation sur terre, dans les airs ou sur l'eau, en particulier dans des véhicules automobiles, par exemple comme pare-brise, lunette arrière, vitres latérales et/ou fenêtre de toit et comme pièce individuelle fonctionnelle, ainsi que comme pièce d'installation dans des meubles, des appareils et des bâtiments, en particulier comme radiateur électrique.
